# EUROPEAN PATENT APPLICATION

(11) **EP 1 014 772 A2**
(43) Date of publication of application: **28.06.2000**
(21) Application number: 99310007.2
(22) Date of filing: 13.12.1999
(51) Int. Cl.: H05K 7/14

(54) **High frequency circuit packaging structure**

(30) Priority: 14.12.1998 JP 35486698
(71) Applicant: Hitachi, Ltd., Chiyoda-ku, Tokyo 101-8010 (JP)
(72) Inventor: Aoyagi, Paul, Kanagawa-ken (JP); Suga, Takashi, Kanagawa-ken (JP); Kasukabe, Susumu, Kanagawa-ken (JP); Kanda, Naoya, Kanagawa-ken (JP); Hayashi, Yoshihiko, Tokyo (JP)
(74) Representative: Hackney, Nigel John

(57) **Abstract**

This invention provides a coaxial cable arranged in a coaxial propagation mode wherein signal wires and surrounding grounds are disposed coaxially, a multilayer printed circuit board arranged in a strip line propagation mode and having three or more layers, comprising signal through holes connected to signal interconnections formed in a signal layer, and a pair of ground through holes connected to ground interconnections of a pair of ground layers sandwiching the signal layer, and sandwiching the signal through holes 30 like a flat plane between them, and a relay connector comprising signal leads connecting the coaxial cable and the multilayer printed circuit board, and a pair of ground plates sandwiching the signal leads, connected in a strip line propagation mode which reduces noise currents and unwanted radiation.

## Description

This invention relates to a coaxial cable and multilayer printed circuit board connected by a relay connector, LSI packages mounted on a printed circuit board, or multilayer printed circuit boards comprising a computer connected by a relay connector using coaxial cable.

As digital circuits become faster and equipped with higher numbers of electrodes, regulations regarding EMI (Electromagnetic Interference), e.g., VCCI regulations in Japan and FCC regulations in the U.S.A., are becoming increasingly stringent (both of these concern unwanted radiation due to electromagnetic waves).

A connector which has a stripline transmission line structure for connecting a plural coaxial cables is disclosed in Japanese Patent Laid-Open Hei 7-220823 (Prior Art 1).

However, in the above-mentioned conventional technique 1, no consideration was given to reducing noise currents and spurious radiation generated due to discontinuities of propagation mode also in the connections between connectors and a multilayer printed circuit board so as to permit, the propagation of high-speed signals.

To mitigate the aforesaid problems, it is preferably an object of this invention to provide a low EMI high speed circuit packaging structure which permits the propagation of high-speed signals by reducing noise currents and spurious radiation due to discontinuities of propagation mode also in the connections between connectors and a multilayer printed circuit board, and moreover achieves compactness, high-density, and low cost.

Preferably, it is a further object of this invention to provide a low EMI high speed circuit packaging structure which permits the propagation of high-speed signals by reducing noise currents and spurious radiation due to discontinuities of propagation mode also in the connections between connectors and a multilayer printed circuit board, wherein multilayer printed circuit boards comprising a compact, high-density, low cost computer are connected by a relay connector using a coaxial cable.

Preferably, in order to attain the above-mentioned objects, this invention provides a coaxial cable arranged in a coaxial propagation mode, an electronic circuit, and a relay connector which connects the coaxial cable and electronic circuit in a stripline propagation mode to reduce noise currents and spurious radiation (including propagation modes similar not to micro-strip line but to stripline).

Preferably, this invention further provides a coaxial cable arranged in a coaxial propagation mode, a multilayer printed circuit board comprising three or more layers, and a relay connector which connects the coaxial cable and multilayer printed circuit board in a stripline propagation mode to reduce noise currents and spurious radiation (including propagation modes similar not to micro-strip line but to stripline).

Preferably, this invention further provides a high-speed circuit packaging structure comprising a coaxial cable arranged in a coaxial propagation mode comprising signal wires and a surrounding ground disposed coaxially, a multilayer printed circuit board having at least three layers and comprising signal through holes connected to signal interconnections formed in a signal layer, a pair of ground through holes respectively connected to ground interconnections of a pair of ground layers sandwiching the signal layer, and disposed in rows so as to sandwich the plural signal through holes like a flat plane between them, and a relay connector comprising signal leads connecting the signal wires of the coaxial cable to the signal through holes of the multilayer printed circuit board, and a pair of ground leads or ground plates which connect the ground of the coaxial cable to the pair of ground through holes of the multilayer printed circuit board so as to symmetrically sandwich the signal leads, connected in a stripline propagation mode to reduce noise currents and spurious radiation (including not microstrip line, but stripline propagation modes).

Preferably, this invention provides a high-speed circuit packaging structure comprising a coaxial ribbon cable wherein plural coaxial cables arranged in a coaxial propagation mode comprising signal wires and a surrounding coaxial ground are disposed in parallel, and a multilayer printed circuit board arranged in a stripline propagation mode, having at least three layers and comprising plural signal through holes disposed in rows connected respectively to the plural signal interconnections formed in the signal layer, plural pairs of ground through holes connected to the ground interconnections of the pair of ground layers sandwiching the signal layer and disposed in rows so as to sandwich the plural signal through holes like a flat plane between them, and a relay connector comprising plural signal leads which connect the signal wires of the coaxial ribbon cable to the plural signal through holes of the multilayer printed circuit board, and plural pairs of ground leads or ground plates which connect the ground of the coaxial ribbon cable to the plural pairs of ground through holes of the multilayer printed circuit board so as to symmetrically sandwich the plural signal leads, connected in a stripline propagation mode to reduce noise currents and spurious radiation (including not microstrip line, but stripline propagation modes).

In the relay connector of the high-speed circuit packaging structure of this invention, the signal leads and pairs of ground leads or ground plates are bent at a point along their length.

Preferably, in the multilayer printed circuit board of the high speed circuit packaging structure of this invention, the signal through holes are disposed so that they substantially have the same depth as that of the signal layer.

Preferably, in the multilayer printed circuit board of the high speed circuit packaging structure of this invention, a ground interconnection pattern electrically connected to the ground through holes is also provided in the signal layer.

Preferably, in this high speed circuit packaging structure, the ends of the signal leads and pairs of ground leads or ground plates of the relay connector are bent, and these bent ends are inserted into and brought in contact with the signal through holes and pairs of ground through holes of the multilayer printed circuit board.

Preferably, this invention provides a high-speed circuit packaging structure comprising a first multilayer printed circuit board arranged in a stripline propagation mode, having at least three layers and comprising plural signal through holes disposed in rows connected respectively to plural signal interconnections formed in a signal layer, and plural pairs of ground through holes connected to ground interconnections of a pair of ground layers sandwiching the signal layer and disposed in rows so as to sandwich the plural signal through holes like a flat plane between them, on which LSI are mounted to form a computer, a second multilayer printed circuit board arranged in a stripline propagation mode, having at least three layers and comprising plural signal through holes disposed in rows connected respectively to plural signal interconnections formed in a signal layer, and plural pairs of ground through holes are connected to ground interconnections of a pair of ground layers sandwiching the signal layer and disposed in rows so as to sandwich the plural signal through holes like a flat plane between them, on which LSI are mounted to form a computer, plural coaxial ribbon cables arranged in a coaxial propagation mode disposed in rows comprising signal wires and surrounding cladding disposed coaxially, a first relay connector comprising plural signal leads connecting the plural signal wires of the coaxial cables to the signal through holes of the first multilayer printed circuit board and pairs of ground leads or ground plates which connect the grounds of the coaxial cables to the pairs of ground through holes of the first multilayer printed circuit board so as to symmetrically sandwich the signal leads, connected in a stripline propagation mode to reduce noise currents and spurious radiation (including not microstrip line, but stripline propagation modes), and a second relay connector comprising plural signal leads connecting the plural signal wires of the coaxial cables to the signal through holes of the second multilayer printed circuit board and pairs of ground leads or ground plates which connect the grounds of the coaxial cables to the pairs of ground through holes of the second multilayer printed circuit board so as to symmetrically sandwich the signal leads, connected in a stripline propagation mode to reduce noise currents and spurious radiation (including not microstrip line, but stripline propagation modes).

This invention further provides a pair of LSI packages mounted on a printed circuit board, and an interconnection structure wherein signal interconnections comprising a stripline propagation mode which reduces noise currents and spurious radiation are sandwiched between ground interconnections so as to connect one of the LSI packages to the other one.

As described above, this invention provides a low EMI, high-speed circuit packaging structure which permits transmission of high-speed signals by reducing noise currents and spurious radiation due to discontinuities of propagation mode by forming a stripline transmission line structure also in the connections between the relay connector and multilayer printed circuit board, and which is compact, high-density and low cost.

Further, this invention provides a low EMI, high-speed circuit packaging structure which permits transmission of high-speed signals by reducing noise currents and spurious radiation due to discontinuities of propagation mode by forming a stripline transmission line structure also in the connections between the relay connector and multilayer printed circuit board, wherein a multilayer printed circuit board forming a compact, high-density and low cost computer, is connected by a relay connector using a coaxial cable.

### BRIEF DESCRIPTION OF THE DRAWINGS

Fig. 1 is a cross-sectional schematic diagram showing a first embodiment of a high speed circuit packaging structure comprising a coaxial ribbon cable, five layer printed circuit board and relay connector according to this invention.

Fig. 2 is a cross-sectional diagram showing the coaxial ribbon cable according to this invention.

Fig. 3 is a cross-sectional schematic diagram showing a second embodiment of the high speed circuit packaging structure comprising the coaxial ribbon cable, five layer printed circuit board and relay connector according to this invention.

Fig. 4 is a plan view showing a ground layer 15a of a multilayer printed circuit board relating to the first and second embodiments.

Fig. 5 is a cross-sectional plan view showing a signal layer 14a of the multilayer printed circuit board relating to the first and second embodiments.

Fig. 6 is a cross-sectional plan view showing a ground layer 15b of the multilayer printed circuit board relating to the first and second embodiments.

Fig. 7 is a cross-sectional plan view showing a signal layer 14b of the multilayer printed circuit board relating to the first and second embodiments.

Fig. 8 is a plan view showing a ground layer 15c of the multilayer printed circuit board relating to the first and second embodiments.

Fig. 9 is a cross-sectional schematic diagram showing a high speed circuit packaging structure comprising a coaxial ribbon cable, six layer printed circuit board and relay connector according to this invention.

Fig. 10 is a cross-sectional schematic diagram showing a third embodiment of the high speed circuit packaging structure comprising the coaxial ribbon cable, five layer printed circuit board and relay connector according to this invention.

Fig. 11 is a plan view showing the ground layer 15a of the multilayer printed circuit board according to the third embodiment.

Fig. 12 is a cross-sectional plan view showing the signal layer 14a of the multilayer printed circuit board according to the third embodiment.

Fig. 13 is a cross-sectional plan view showing the ground layer 15b of the multilayer printed circuit board according to the third embodiment.

Fig. 14 is a cross-sectional plan view showing the signal layer 14b of the multilayer printed circuit board according to the third embodiment.

Fig. 15 is a plan view showing the ground layer 15c of the multilayer printed circuit board according to the third embodiment.

Fig. 16 is a cross-sectional schematic diagram showing a fourth embodiment of the high speed circuit packaging structure comprising the coaxial ribbon cable, three layer printed circuit board and relay connector according to this invention.

Fig. 17 is a plan view showing the ground layer 15a of the multilayer printed circuit board according to a fourth embodiment.

Fig. 18 is a cross-sectional plan view showing the signal layer 14a of the multilayer printed circuit board according to the fourth embodiment.

Fig. 19 is a plan view showing the ground layer 15b of the multilayer printed circuit board according to the fourth embodiment.

Fig. 20 is a figure showing a noise current frequency characteristic generated in the sheath of a coaxial cable having a stripline transmission line connection according to this invention, and of a microstrip transmission line connection as a comparison.

Fig. 21 is a figure showing a 3m distant field generated by the stripline transmission line connection according to this invention and the microstrip transmission line connection as a comparison.

Fig. 22 is a diagram showing electric force lines and magnetic force lines of a cross-section of a coaxial cable according to this invention.

Fig. 23 is a diagram showing electric force lines and magnetic force lines of a cross-section of a stripline transmission line according to this invention.

Fig. 24 is a diagram showing electric force lines and magnetic force lines of a cross-section of a microstrip transmission line as a comparison.

Fig. 25 is a cross-sectional diagram showing the first embodiment of the relay connector taken along a line A-A in Fig. 1.

Fig. 26 is a cross-sectional diagram showing the second embodiment of the relay connector taken along the line A-A in Fig. 1.

Fig. 27 is a cross-sectional diagram showing the third embodiment of the relay connector taken along the line A-A in Fig. 1.

Fig. 28 is a cross-sectional diagram showing the fourth embodiment of the relay connector taken along the line A-A in Fig. 1.

Fig. 29 is a cross-sectional diagram showing a fifth embodiment of the relay connector taken along the line A-A in Fig. 1.

Fig. 30 is a cross-sectional diagram showing a coaxial cable in which one drain line is installed.

Fig. 31 is a cross-sectional diagram showing a coaxial cable in which two drain lines are installed.

Fig. 32 is a cross-sectional diagram showing a coaxial cable in which three drain lines are installed.

Fig. 33 is a cross-sectional diagram showing a coaxial cable in which four drain lines are installed.

Fig. 34 is a cross-sectional schematic diagram showing the fifth embodiment of the high speed circuit packaging structure comprising a coaxial cable and connector according to this invention.

Fig. 35 is a cross-sectional schematic diagram showing a sixth embodiment of the high speed circuit packaging structure comprising a coaxial cable and package according -to this invention.

Fig. 36 is a cross-sectional schematic diagram showing a seventh embodiment of the high speed circuit packaging structure (surface mounted structure) comprising an interconnection structure connecting LSI packages mounted on the printed circuit board according to this invention.

Fig. 37 is a view in perspective showing an eighth embodiment of the high speed circuit packaging structure comprising a computing system comprising a multilayer printed circuit board forming a computer and a multilayer printed circuit board forming a computer according to this invention, connected by a relay connector and coaxial cable.

### DESCRIPTION OF THE PREFERRED EMBODIMENTS

One embodiment of the low EMI (electromagnetic interference) packaging structure according to this invention will now be described referring to the drawings.

Specifically, the low EMI packaging structure according to this invention is a high-speed circuit packaging structure comprises, for example, a coaxial cable 10, a printed circuit board 16 having at least three layers built into a stripline transmission line, and a relay connector 100 which has a ground structure (stripline transmission line structure) sandwiching a signal wire which connects the coaxial cable 10 and the printed circuit board 16. The relay connector 100 has a ground structure sandwiching a signal wire so that, in the coaxial cable 10 and between the three or more layers of the printed circuit board 16 formed from a printed circuit board or the like, the ground current distribution flows as nearly as possible parallel to the signal wire current, and as a result, noise currents and spurious radiation due to discontinuities in the propagation mode are reduced. Hence, at least two contact points with a pair of grounds 25, 13 sandwiching the signal wires 26, 12 forming the relay connector 100, are formed in a ground 20 of the coaxial cable 10, and between ground interconnections 15 (32) of the multilayer printed circuit board 16.

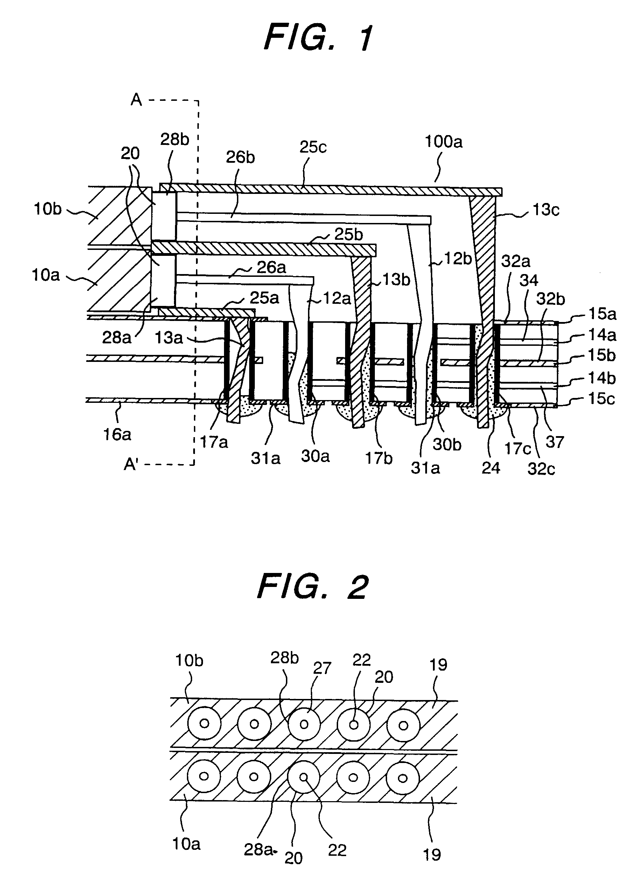

As shown in Fig. 2, coaxial ribbon cables 10a, 10b are surrounded with a PVC (polyvinyl chloride) insulator 19, comprising, for example, rows of plural coaxial cables 28a, 28b. The coaxial cables 28a and 28b comprise a center conductor 22 which is a signal wire, the ground 20 formed of metal foil, etc., and a dielectric 27 interposed between the center conductor 22 and ground 20. The diameter of the ground 20 is approximately 0.65mm and the diameter of the center conductor 22 is approximately 0.19mm, relative permittivity of the dielectric 27 is 2.1, and the characteristic impedance of the coaxial cable 28 is therefore about 50 ohms.

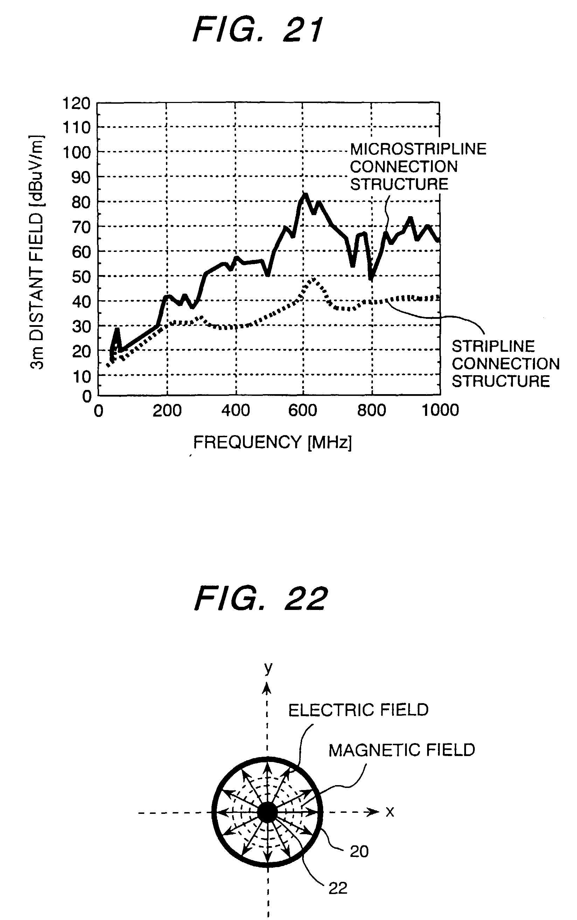

The propagation mode of the coaxial cables 28a, 28b comprising the coaxial ribbon cables 10a, 10b is thus a TEM (transverse electromagnetic) electromagnetic field distribution which is symmetrical about the line y=ax, i.e., a TEM propagation mode, as shown in Fig. 22. a is a real number.

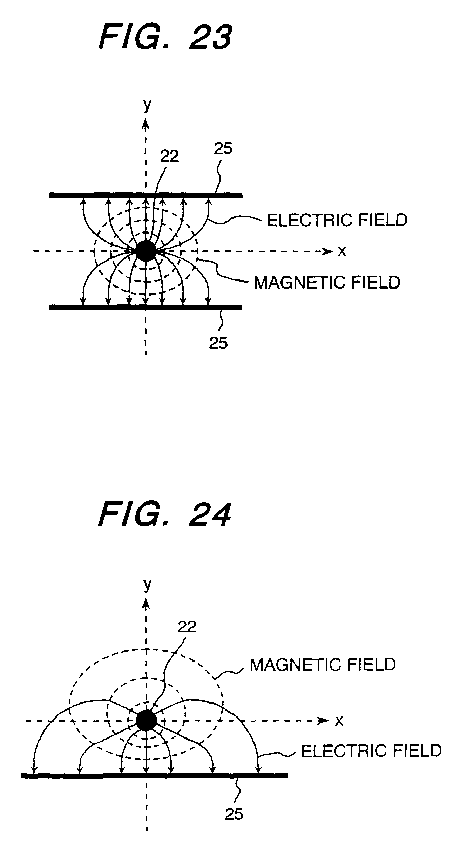

The multilayer printed circuit board 16 of three or more layers formed from a printed circuit board, etc. comprises, for example, five layers, i.e., signal layers 14a (34), 14b (37), ground layers 15a (32a), 15b (32b) and 15c (32c), and an insulating layer which insulates between these layers. That is, the multilayer printed circuit board 16 has a two-stage stripline structure wherein the signal layer 14a (34) is sandwiched between the ground layer 15a (32a) and ground layer 15b (32b), and the signal layer 14b (37) is sandwiched between the ground layer 15b (32b) and ground layer 15c (32c). The thickness of the insulating layer between these layers is approximately 0.4mm. Thus, the multilayer printed circuit board 16 is formed by a stripline transmission line wherein the signal wires 22 (14a; 14b) are sandwiched by two ground planes 25 (15a, 15b; 15b, 15c) as shown in Fig. 23, and this propagation mode is a TEM (transverse electromagnetic) field distribution which is symmetrical about the line x=0 and the line y=0, i.e., a TEM propagation mode.

As described above, the coaxial cables 28a, 28b and the multilayer printed circuit board 16 are formed in a propagation mode wherein signal currents and ground currents flow parallel to each other but in reverse directions, so the Hertzian waves generated by the signal currents and the Hertzian wave generated by the ground currents cancel each other, and emit only a small spurious radiation.

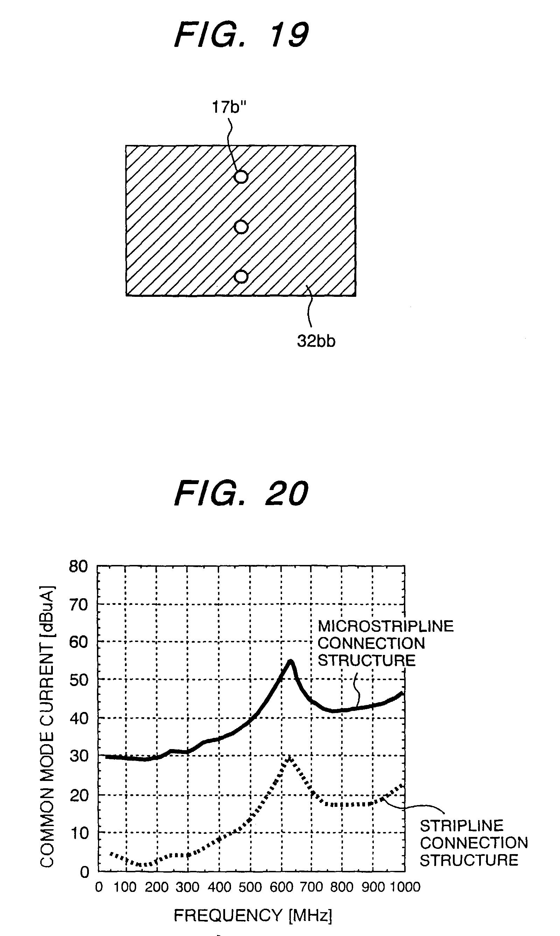

According to this invention therefore, in the connection of the relay connector 100 which connects the coaxial cables 28a, 28b to the multilayer printed circuit board 16 (in particular the connection of the relay connector 100 to the multilayer printed circuit board 16), discontinuities are reduced by the stripline transmission line, and in comparison to the microstripline transmission line structure shown in Fig. 24 (a microstripline transmission line is formed by one ground plane 25 and a signal wire 22, which is symmetrical only about the line x=0), a reduction of at least about 20dB of spurious radiation at frequencies of 300MHz or more, which is a problem in high-speed signal transmission, is achieved both for noise current (common mode current [dBuA] and 3m distant field (dBuV/m), as shown in Fig. 20 and Fig. 21.

Next, a first embodiment 100a of the mounting structure of the relay connector of the stripline transmission line structure, which connects the coaxial ribbon cables 10a and 10b to, for example, the five layer printed circuit board 16a, will be described referring to Fig. 1.

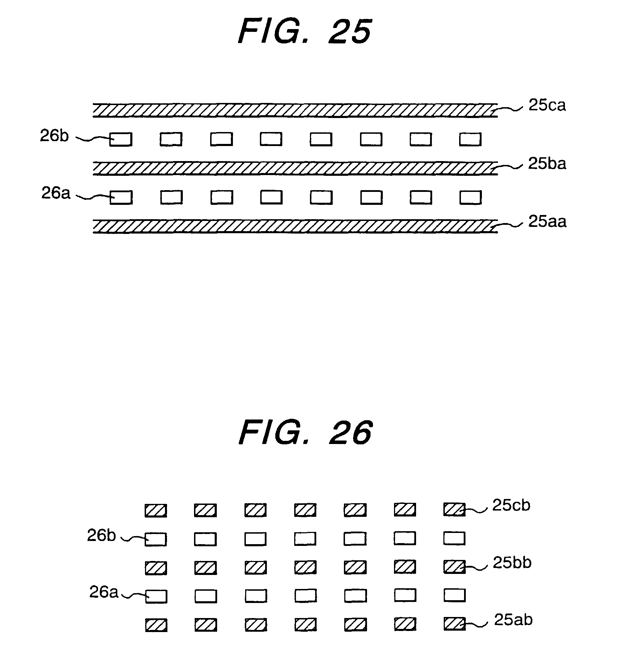

The relay connector 100a has a stripline transmission line structure comprising a coaxial cable part comprising two rows of signal leads 26a, 26b (shown by a section taken along A-A' of Fig. 1 in Figs. 25-29) joined by impressing or the like and of different lengths so as to extend the center conductor 22 of the coaxial cables 28a, 28b disposed in rows in the two coaxial ribbon cables 10a, 10b, and three ground planes (ground leads) 25a, 25b, 25c (shown by a section taken along A-A' of Fig. 1 in Figs. 25-29) joined by impressing or soldering to an extended part of the ground 20 so that they are facing the upper and lower surfaces of the exposed ends of the ground 20 of the coaxial cables 28a, 28b and sandwich the two rows of signal leads 26a, 26b, and a printed circuit board part comprising two rows of signal leads 12a, 12b (substantially identical to the state shown in Figs. 25-29) which are formed in an L-shape with the ends of the signal leads 26a, 26b of the coaxial cable part, and three rows of ground leads 13a, 13b, 13c (substantially identical to the state shown in Figs. 25-29) which are formed in an L-shape with the ends of the three ground planes (ground leads) 25a, 25b, 25c sandwiching the two rows of signal leads 12a, 12b.

Fig. 25 shows a first embodiment of the transmission line structure in the relay connector 100. In this stripline transmission line structure, two rows of signal leads 26a, 26b are sandwiched by two thin plate-like ground planes 25aa, 25ba and two thin plate-like ground planes 25ba, 25ca.

Fig. 26 shows a second embodiment of the transmission line structure in the relay connector 100. In this stripline transmission line structure, the two rows of signal leads 26a, 26b are sandwiched by the two rows of ground leads 25ab, 25bb disposed like a thin plate, and the two rows of ground leads 25bb, 25cd disposed like a thin plate.

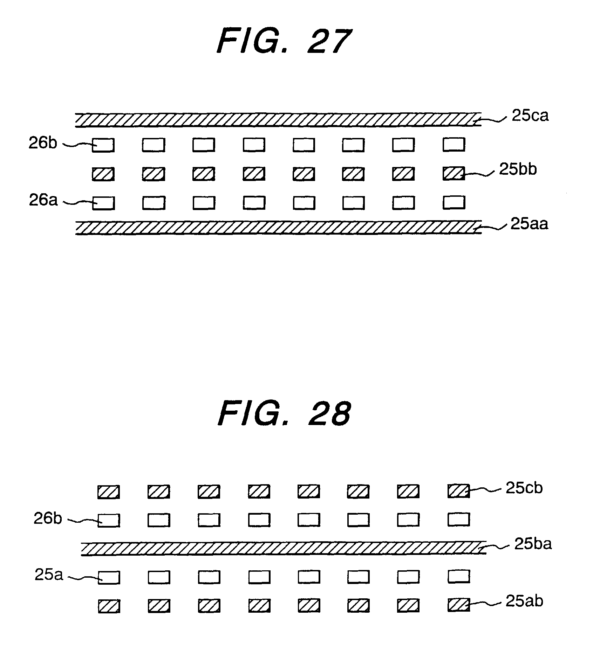

Fig. 27 shows a variation of the second embodiment of the transmission line structure in the relay connector 100. In this stripline transmission line structure, the two rows of signal leads 26a, 26b are sandwiched by the thin plate-like ground plane 25aa, the row of ground leads 25bb disposed like a thin plate, and the thin plate-like ground plane 25ca.

Fig. 28 shows another variation of the second embodiment of the transmission line structure in the relay connector 100. In this stripline transmission line structure, the two rows of signal leads 26a, 26b are sandwiched by the row of ground leads 25ab disposed like a thin plate, one thin plate-like ground plane 25ba, and a row of ground leads 25cb disposed like a thin plate.

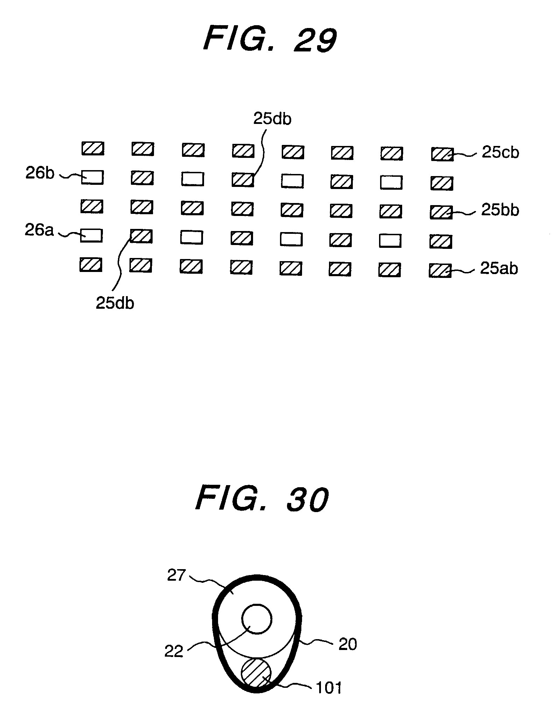

Fig. 29 shows yet another variation of the second embodiment of the transmission line structure in the relay connector 100. In this stripline transmission line structure, the two rows of signal leads 26a, 26b are sandwiched from above and below by the two rows of ground leads 25ab, 25bb disposed like thin plates, and the two rows of ground leads 25bb, 25cb disposed like thin plates, and are also sandwiched from left and right by ground leads 25db.

When the three rows of ground leads 13a, 13b, 13c are formed in the shape of plates as shown in Figs. 25, 27 and 28, the ends which are inserted in through holes must be formed in the shape of pins (leads).

By bending the ends of the two rows of signal leads 12a, 12b in the printed circuit board part of the relay connector 100a and inserting them into through holes 30a, 30b connected to signal interconnections of the signal layers 14a, 14b formed in the multilayer printed circuit board 16a, they can be brought into partial contact and pressed in. Also, by bending the ends of the three rows of ground leads 13a, 13b, 13c, and inserting these ends into through holes 17a, 17b, 17c connected to grounds in ground layers 15a, 15b, 15c formed in the multilayer printed circuit board 16a, they can be brought into partial contact and pressed in. Further, if the bent ends of the two rows of signal leads 12a, 12b are joined to the through holes 30a, 30b, 30c formed in the multilayer printed circuit board 16a by solder 24, and the bent ends of the three rows of ground leads 13a, 13b, 13c are joined to the through holes 17a, 17b, 17c formed in the multilayer printed circuit board 16a by the solder 24, connection with the multilayer printed circuit board 16a is ensured.

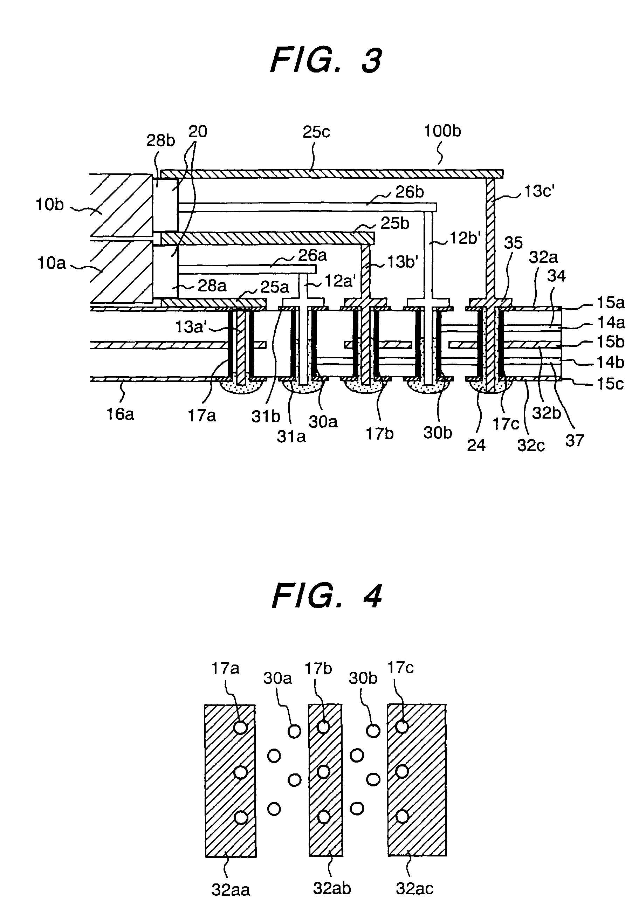

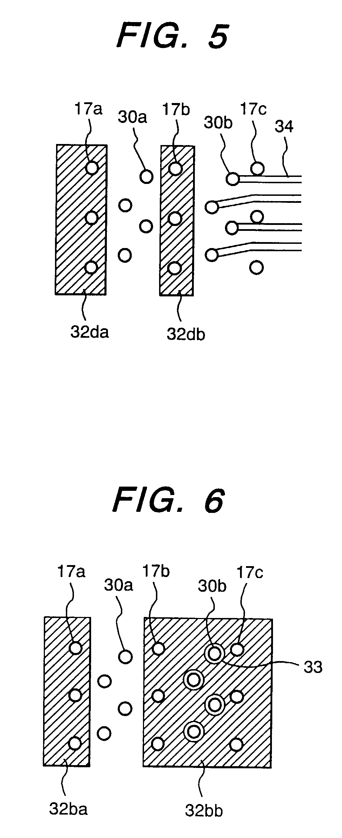

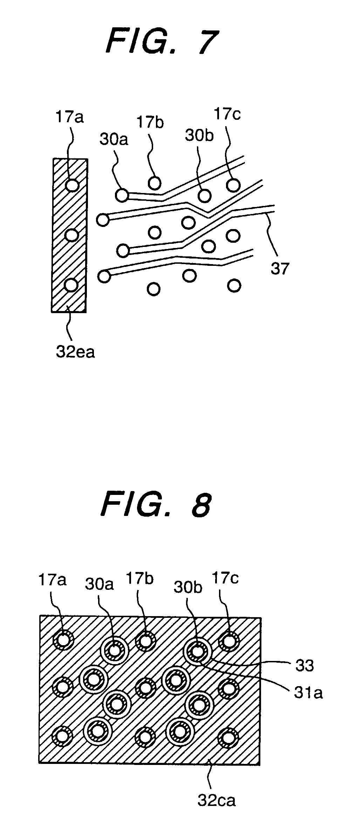

That is, all the rows of signal leads 12a and 12b and ground leads 13a, 13b 13c on the printed circuit board side of the relay connector 100a may be connected by inserting them into the signal through holes 30a, 30b and the ground through holes 17a, 17b, 17c which were provided in the multilayer printed circuit board 16a. These through hole structures are filled with air and formed in the shape of a metal pipe (metal plated film, etc.) of diameter about 0.5-1mm. Specifically, the through hole structures are formed by machining, e.g., drilling, the multilayer printed circuit board on which the ground pattern or signal interconnection pattern is laminated, or by masking parts other than the through holes, machining by irradiation with an energy beam (laser beam, ion beam, electron beam or plasma beam, etc.), masking parts which do not require plating, and then plating the interior of the through holes with copper or the like. The signal through hole 30a is electrically connected to a signal wire 37 of the signal layer 14b, as shown in Fig. 7, and the signal through hole 30b is electrically connected to a signal wire 34 of the signal layer 14a, as shown in Fig. 5. The ground through holes 17a, 17b, 17c are electrically connected to the ground interconnections 32a, 32b, 32c of the ground layers 15a, 15b, 15c, as shown in Figs. 4, 6 and 8. The signal through holes 30a, 30b and ground through holes 17a, 17b, 17c are all formed so that the multilayer printed circuit board 16a is penetrated up to the ground layer 15c.

The connections between the signal through holes 30a, 30b and the rows of signal leads 12a, 12b, and the connections of the ground through holes 17a, 17b, 17c to the ground leads 13a, 13b, 13c, are made by press-in contact, for example, as shown in Fig. 1. Specifically, the leads are brought in contact with the through holes to form press-in contacts by providing bent parts in the leads inserted in the through holes. Further, the connections between the signal through holes 30a, 30b and the signal leads 12a, 12b, and the connections between the ground through holes 17a, 17b, 17c and the ground leads 13a, 13b, 13c, can be ensured by joining with solder 24. In this case, it is convenient to make the junction with the solder 24 by forming metal pads 31a on the end face of the signal through holes 30a, 30b (or on the surface of the ground layer 15c).

Moreover, in the connection of the relay connector 100a formed with a stripline transmission line structure and the multilayer printed circuit board 16a, a high density connection package can be realized by alternately arranging the two rows of signal leads 12a, 12b as shown by the through holes 30a, 30b in Fig. 4-Fig. 8.

In the vicinity of the two-stage coaxial ribbon cables 10a, 10b on the coaxial cable ribbon side of the relay connector 100a, the two rows of signal leads 26a, 26b joined by caulking or the like to the center conductors 22 of the coaxial cables 28a, 28b and the three ground planes 25a, 25b, 25c, may be supported by molding with an insulating material. The three ground planes 25a, 25b, 25c are made to project on the coaxial cable side from the mold insulating material, and the extended parts of the grounds 20 of the coaxial cables 28a, 28b are joined by crimping or soldering to the three ground planes 25a, 25b, 25c. Subsequently, the ends of the two coaxial ribbon cables 10a, 10b connected to the relay connector 100a can be formed in one piece with the mold insulating material via the three ground planes 25a, 25b, 25c by molding with an insulating material together with the projecting three ground planes 25a, 25b, 25c. These can also be covered.

Next, the construction of the multilayer printed circuit board 16a of the first embodiment, including the connection of the relay connector 100a to the multilayer printed circuit board 16a, will be described. The multilayer printed circuit board 16a has a two row strip line transmission line structure comprising the signal layers 14a, 14b and the ground layers 15a, 15b, 15c. The signal layer 14a is sandwiched by the ground layers 15a, 15b, and the signal layer 14b is sandwiched by the ground layers 15b, 15c.

Fig. 4 shows a ground pattern on the ground layer 15a of the multilayer printed circuit board 16a. As shown in Fig. 4, the ground interconnection 32 in the vicinity of the signal through holes 30a, 30b is eliminated, and the ground through holes 17a, 17b, 17c are connected to ground interconnections 32aa, 32ab, 32ac.

On the surface of the ground layer 15a, therefore, the set of signal through holes 30a is sandwiched by the ground interconnection 32aa and ground interconnection 32ab to form a stripline structure, and the set of signal through holes 30b is also sandwiched by the ground interconnection 32ab and ground interconnection 32ac to form a stripline structure. It should be noted that, in the ground layer 15a, it is unnecessary to connect the ground through hole 17b to the ground interconnection 32ab directly, and the connection can be made via the ground interconnections of other layers. Also, the metal pads 31 connected to the signal through holes 30a, 30b and ground through holes 17a, 17b, 17c may be provided on the ground layer front surface of the multilayer printed circuit board 16a.

Fig. 5 shows the signal interconnection pattern on the signal layer 14a of the multilayer printed circuit board 16a. Specifically, the ground through holes 17a, 17b are connected to ground interconnections 32da, 32db. The signal wire 34 connected to the signal through hole 30b is wired between the ground through holes 17c. Hence, on the surface of the signal layer 14a, the set of signal through holes 30b is sandwiched by the ground interconnection 32db and the ground through holes 17c located at various points to form a structure similar to a stripline structure, and the signal wire 34 connected to the set of signal through holes 30b is sandwiched by a ground interconnection 32ac and ground interconnection 32bb to form a stripline structure, so it is preferable to provide the ground interconnection 32db.

On the surface of the signal layer 14a, the set of signal through holes 30a is sandwiched by the ground interconnection 32da and ground interconnection 32db to form a stripline structure. In the signal layer 14a, it is unnecessary to connect the ground through holes 17a, 17b to the ground interconnections 32da, 32db directly. Also, the set of signal wires 34 is sandwiched by the ground interconnection 32ac and the ground interconnection 32bb to form a stripline structure. The set of signal through holes 30a, in the ground layer 15a, is sandwiched by the ground interconnection 32aa and ground interconnection 32ab, and, in the ground layer 15b, is sandwiched by the ground interconnection 32ba and ground interconnection 32bb so as to form a stripline structure. Therefore, it is not absolutely necessary to sandwich the set of signal through holes 30a by the ground interconnection 32da and ground interconnection 32db in the signal layer 14a, and it is possible to dispense with the ground interconnections 32da, 32db. A small amount of spurious radiation may arise in the signal layer 14a, but this is not a problem.

Fig. 6 shows a ground pattern or the like on the ground layer 15b of the multilayer printed circuit board 16a. As shown in Fig. 6, the ground interconnection 32ba,32bb in the vicinity of the signal through hole 30a is eliminated, the ground interconnection 32bb in the vicinity of the signal through hole 30a is eliminated by a hole 33, the ground through hole 17a is connected to the ground interconnection 32ba, and the ground through holes 17b, 17c are connected to the ground interconnection 32bb. The reason for making the ground interconnection 32bb wider in this way is to connect the ground through hole 17b and ground through hole 17c in this ground layer 15b. For this purpose, the hole 33 of diameter approximately 0.7-1.2mm is opened in the ground interconnection 32bb, and insulated from the signal through hole 30b. On the surface of the ground layer 15b, the signal through hole 30a is sandwiched by the ground interconnection 32ba and ground interconnection 32bb to form a stripline structure. Moreover, it is not absolutely necessary to connect the ground through hole 17a to the ground interconnection 32ba in the ground layer 15b.

Fig. 7 shows a signal interconnection pattern or the like on the signal layer 14b of the multilayer printed circuit board 16a. As shown in Fig. 7, all the ground through holes 17 are connected to a ground interconnection 32ea. The signal wire 37 connected to the signal through hole 30a is wired between the ground through holes 17b, 17c, and between the signal through holes 30b. Hence, on the surface of the signal layer 14b, the set of signal through holes 30a is sandwiched by the ground interconnection 32ea and ground through holes 17b located at various points to form a structure similar to a stripline structure, and the signal wire 37 connected to this set of signal through holes 30a is sandwiched by the ground interconnection 32bb and a ground interconnection 32ca to form a stripline structure, so it is preferable to provide the ground interconnection 32ea. However, it is also possible to dispense with the ground interconnection 32ea. In this case, the signal wire 37 may be wired between the ground through holes 17a. If the signal wire 37 is wired between the ground through holes 17a in this way, a ground interconnection connected to the set of ground through holes 17b may also be provided.

Fig. 8 shows a ground pattern or the like on the surface of the ground layer 15c of the multilayer printed circuit board 16a. As shown in Fig. 8, the metal pads 31a of the signal through holes 30a and the metal pads 31a of the signal through holes 30b are separated and electrically isolated by opening the holes 33 in the ground interconnection 32ca which is considerably widened.

Further, the pads 31a of the ground through holes 17a, 17b, 17c are joined and connected in one piece with the ground interconnection 32ca. In this case, it is as if the pads 31 of the ground through holes 17a, 17b, 17c do not actually exist. The metal pads 31a of the signal through holes 30a, 30b are provided for easy soldering.

Next, a second embodiment 100b of a stripline transmission line relay connector packaging structure connecting the coaxial ribbon cables 10a, 10b to, for example, a five layer printed circuit board 16b, will be described using Fig. 3.

In the second embodiment, the difference from the first embodiment is in the connections between the signal through holes 30a, 30b and set of signal leads 12a', 12b', and in the connections between the ground through holes 17a, 17b, 17c and ground leads 13a', 13b', 13c'. Specifically, anvil-shaped parts (wide parts) 35 are provided in a set of signal leads 12a', 12b' and the ground leads 13a', 13b', 13c' on the upper surface of the multilayer printed circuit board 16b, the ends of these parts being straight. The anvil-shaped parts 35 of the set of signal leads 12a', 12b' and the ground leads 13a', 13b', 13c may thereby be brought into contact with and electrically connected to metal pads 31b of the aforesaid through holes 30a, 30b and 17a, 17b, 17c. In this second embodiment also, the reliability of the connections between the signal through holes 30a, 30b and set of signal leads 12a', 12b', and the connections between the ground through holes 17a, 17b, 17c and ground leads 13a', 13b', 13c' can be improved by joining with the solder 24. Further, in this embodiment also, it is convenient from the viewpoint of joining with the solder 24 to form the metal pads 31a on the end faces of the signal through holes 30a, 30b (on the surface of the ground layer 15c).

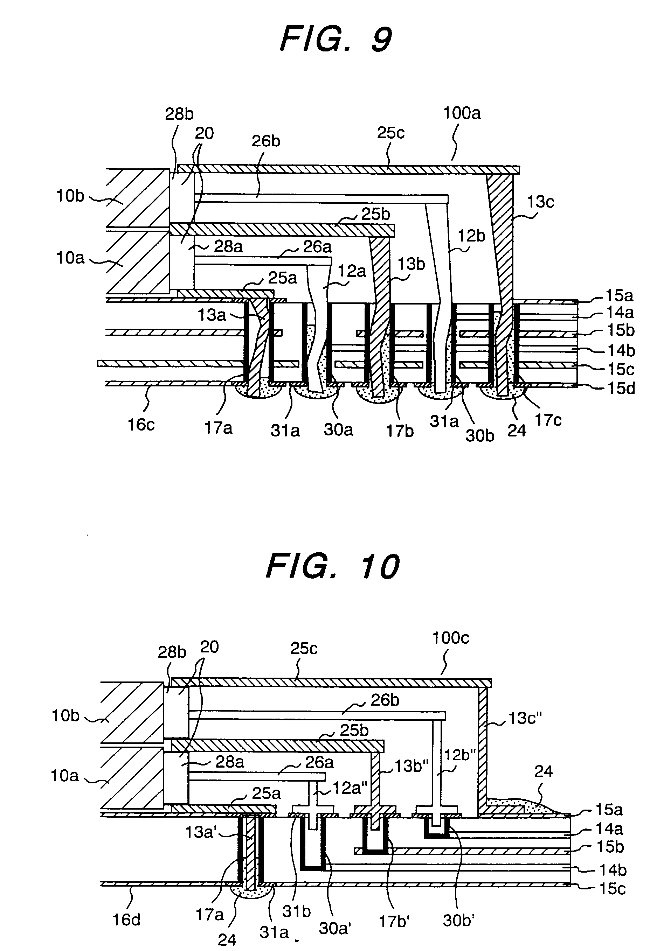

The aforesaid first and second embodiments were described for the case where the multilayer printed circuit boards 16a, 16b had five layers, but a multilayer printed circuit board 16c formed of six layers may be provided as shown in Fig. 9.

In the case of a six layer multilayer printed circuit board 16c, the construction is that of the packaging connecting structure between the relay connector 100a and the multilayer printed circuit board 16c shown in Fig. 9. Specifically, in the structure of the six layer printed circuit board 16c, the signal layers 14a, 14b and ground layers 15a, 15b, 15c have the same structure as those of the five layer printed circuit boards 16a, 16b shown in Fig. 1. However, in the case of the structure of the six layer printed circuit board 16c, a ground layer 15d is provided underneath the ground layer 15c.

As described above, in the first and second embodiments, to make it easier to form the through holes 30a, 30b, 17a, 17b, 17c in the multilayer printed circuit boards 16a, 16b, 16c, the through holes 30a, 30b, 17a, 17b, 17c were bored right through from the front surface to the back surface of the multilayer printed circuit boards 16a, 16b, 16c. Therefore, the signal interconnections 37 and signal through holes 30b are adjacent to one another without a ground interconnection between them as shown in Fig. 7, and it is possible that in the case of signals having a frequency of 200 MHz or higher, high-speed signals would not be transmitted with high reliability due to mutual interference. However, the signal interconnections 37 are sandwiched by the ground interconnection 32bb and ground interconnection 32ca, and on the surface of the signal layerl4b, the signal through holes 30b are sandwiched by the ground through hole 17b and ground through hole 17c, so mutual interference is dampened and is not such a problem.

Next, a third embodiment 100c of a stripline transmission line relay connector packaging structure connecting the coaxial ribbon cables 10a, 10b to, for example, a five layer printed circuit board 16d, will be described using Fig. 10. This third embodiment prevents, for example, the signal interconnections 37 and signal through holes 30b shown in Fig. 7 from coming close to each other without interposing a ground interconnection.

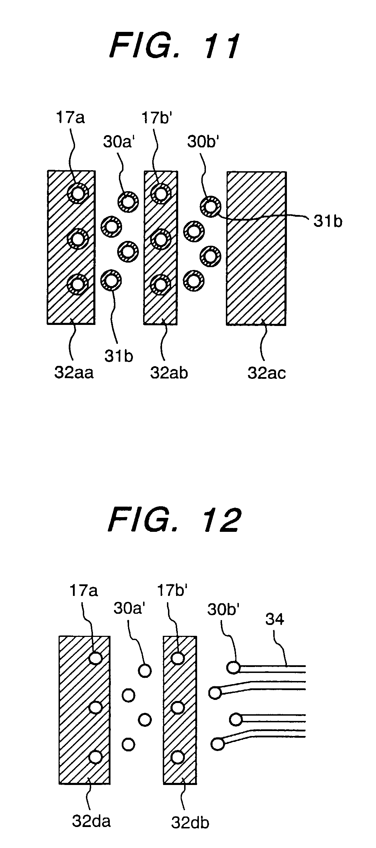

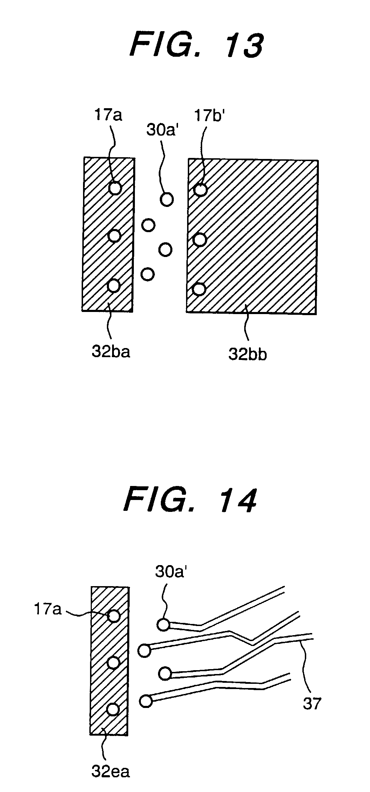

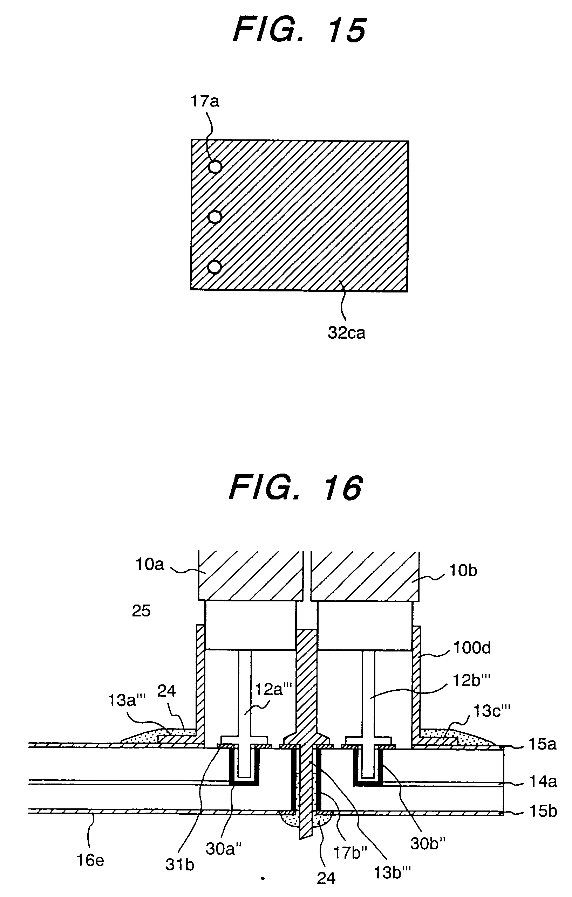

The connections with the coaxial ribbon cables in the relay connector 100c are identical to those of the first and second embodiments. However, the connections to the multilayer printed circuit board 16d in the relay connector 100c are comprised as follows. A set of signal leads 12a", 12b" and ground leads 13a', 13b" are respectively inserted in signal through holes 30a', 30b' and ground through holes 17a, 17b' provided in the multilayer printed circuit board 16d. This through hole structure is formed in the shape of a metal pipe (e.g., metal-plated film) whereof the center is filled with air and having a diameter of approximately 0.5-1mm. The signal through hole 30a' extends through to the signal layer 14b (having a depth substantially up to the signal layer 14b), and is electrically connected to the signal interconnection 37 of the signal layer 14b as shown in Fig. 14. The signal through hole 30b' extends through to the signal layer 14a (having a depth substantially up to the signal layer 14a), and is electrically connected to the signal interconnection 34 of the signal layer 14a as shown in Fig. 12. The ground through hole 17a extends through to the ground layer 15c and is electrically connected to the wide ground interconnection 32ca of the ground layer 15c as shown in Fig. 15. The ground through hole 17b' extends through to the ground layer 15b (having a depth substantially up to the ground layer 15b), and is electrically connected to the ground interconnection 32bb of the ground layer 15b as shown in Fig. 13. The ground through hole 17a is electrically connected to the ground interconnection 32aa of the ground layer shown in Fig. 11. The end of a ground lead 13c" which is for example bent and widened comes in direct contact with the ground interconnection 32ac of the ground layer 15a shown in Fig. 11, and is joined with, for example, the solder 24. The ground through hole 17a is formed up to the ground layer 15c, the signal through hole 30a' is formed up to the signal layer 14b, the ground through hole 17b' is formed up to the ground layer 15b and the signal through hole 30b' is formed up to the signal layer 14a, i.e., these through holes must be formed to different depths. Through holes having the desired depth may be formed by masking parts of the multilayer printed circuit board 16d, whereon the ground pattern or signal interconnection pattern has been laminated, excepting the through holes to be machined, irradiating with an energy beam (e.g., laser beam, ion beam, electron beam or plasma beam), and for example controlling the irradiation time or controlling irradiation by analyzing the mass or charged particles produced in the machined parts (through holes). Subsequently, the through hole structures having different depths are obtained by masking parts which it is not necessary to plate, and plating the interior of the through holes with copper or the like. Alternatively, through holes having the desired depth may be formed by machining, e.g., drilling, the multilayer printed circuit board 16d whereon the ground pattern or signal interconnection pattern has been laminated. Subsequently, the through hole structures having different depths are obtained by masking parts which it is not necessary to plate, and plating the interior of the through holes with copper or the like.

For the signal through hole 30a', ground through hole 17b' and signal through hole 30b', through hole structures having different depths may be obtained by forming the through holes one by one in the stage prior to lamination, filling the interior of these through holes with an electrically conducting material, and laminating them.

The connections between the signal through holes 30a', 30b' and signal leads 12a", 12b", and the connections between the ground through holes 17a, 17b' and ground leads 13a', 13b" may be realized by for example forming the wide parts (anvil shaped parts) 35 in the leads 12a", 12b" and the leads 13a', 13b" of the relay connector 100c as shown in Fig. 10, and bringing the wide parts (anvil-shaped parts) 35 into contact with the metal pads 31b of the through holes to make an electrical connection. However, if a satisfactory electrical connection cannot be made merely by bringing these parts into contact, a join may be made using solder or adhesive containing conducting particles.

Next, the construction of the multilayer printed circuit board 16d including the connections between the relay connector 100c and multilayer printed circuit board 16d according to the third embodiment, will be described. The multilayer printed circuit board 16d has a two-row stripline transmission line structure comprising the signal layers 14a, 14b and the ground layers 15a, 15b, 15c. The signal layer 14a is sandwiched by the ground layers 15a, 15b, and the signal layer 14b is sandwiched by the ground layers 15b, 15c.

Fig. 11 shows a ground pattern or the like on the ground layer 15a of the multilayer printed circuit board 16d. As shown in Fig. 11, the ground interconnection 32 in the vicinity of the signal through holes 30a', 30b' is eliminated, and the ground through holes 17a, 17b', 17c' are respectively connected to the ground interconnections 32aa, 32ab, 32ac. Hence, on the surface of the ground layer 15a, the set of signal through holes 30a' is sandwiched by the ground interconnection 32aa and ground interconnection 32ab to form a stripline structure, and the set of signal through holes 30b' is also sandwiched by the ground interconnection 32ab and ground interconnection 32ac to form a stripline structure. It may be noted that in the ground layer 15a, it is unnecessary to connect the ground through hole 17b' to the ground 32ab directly, and the connection may be made via ground interconnections in other layers. Further, the metal pads 31b connected respectively to the signal through holes 30a, 30b and ground through holes 17a, 17b, 17c, may be provided on the ground layer front surface of the multilayer printed circuit board 16d, and brought in contact with the wide parts 35 of the leads 12a", 12b" and leads 13a', 13b".

Fig. 12 shows a signal interconnection pattern or the like on the signal layer 14a of the multilayer printed circuit board 16d. As shown in Fig. 12, the ground through holes 17a, 17b' are respectively connected to the ground interconnections 32da, 32db. The signal wire 34 connected to the signal through hole 30b' having a depth substantially up to the signal layer 14a, is provided. Hence, on the surface of the signal layer 14a, the set of signal through holes 30a' is sandwiched by the ground interconnection 32da and ground interconnection 32db to form a stripline structure. On the surface of the signal layer 14a, the ground interconnection 32db is provided on one side of the set of signal through holes 30b' and therefore locally forms a microstrip structure shown in Fig. 24. However, as the signal interconnection 34 connected to this is sandwiched by the ground interconnection 32ac and ground interconnection 32b to form the stripline structure shown in Fig. 23, there is almost no problem regarding spurious radiation. Moreover, it is possible to eliminate the local microstrip structure by providing the ground through hole 17c from the front surface to the back surface. It may be noted that in the signal layer 14a, it is unnecessary to connect the ground through holes 17a, 17b' respectively to the ground interconnections 32da, 32db directly.

Fig. 13 shows a ground pattern or the like on the ground layer 15b of the multilayer printed circuit board 16d. As shown in Fig. 13, the ground interconnection 32 in the vicinity of the signal through hole 30a' is eliminated, the ground through hole 17a is connected to the ground interconnection 32ba, and the ground through hole 17b' is connected to the wide ground interconnection 32bb. Hence, on the surface of the ground layer 15b, the set of signal through holes 30a' is sandwiched by the ground interconnection 32ba and ground interconnection 32bb to form a stripline structure. It should be noted that, in the ground layer 15b, it is not absolutely necessary to connect the ground through hole 17a to the ground interconnection 32ba.

Fig. 14 shows a signal interconnection pattern or the like on the signal layer 14b of the multilayer printed circuit board 16d. As shown in Fig. 14, all of the ground through holes 17 are connected to the ground interconnection 32ea. Unlike the case of Fig. 7, the signal wire 37 connected to the signal through hole 30a' having a depth substantially up to the signal layer 14b is wired without any particular need for the signal through hole 30b'. Therefore, as the ground interconnection 32bb is present between the signal wire 37 and lower end of the signal through hole 30b', so the signal wire 37 and signal through hole 30b' do not come close to each other without a ground interconnection between them. On the surface of the signal layer 14b, the set of signal through holes 30a' locally forms the microstrip structure shown in Fig. 24 relative to the ground interconnection 32ea. However, as the signal wire 37 connected to this signal through hole 30a' is sandwiched by the ground interconnection 32bb and ground interconnection 32ca to form the stripline structure shown in Fig. 23, there is almost no problem regarding spurious radiation. Moreover, it is possible to eliminate the local microstrip structure by providing the ground through hole 17b from the front surface to the back surface. As described above, it is preferable to provide the ground interconnection 32ea.

Fig. 15 shows a ground pattern or the like formed on the ground layer 15c of the multilayer printed circuit board 16d. As shown in Fig. 15, the ground through hole 17a is joined and connected with the ground interconnection 32ca.

As described above, according to the third embodiment, it is preferable that the ground through hole 17b' is formed from the front face to the back face of the multilayer printed circuit board 16d, and that the ground through hole 17c is formed from the front face to the back face of the multilayer printed circuit board 16d.

Next, a fourth embodiment 100d of a stripline transmission line relay connector packaging structure connecting the coaxial ribbon cables 10a, 10b to, for example, a three-layer printed circuit board 16e, will be described referring to Fig. 16. According to this fourth embodiment, the coaxial ribbon cables 10a, 10b are connected to the multilayer printed circuit board 16e effectively at right angles by the relay connector 100d.

According to the fourth embodiment, the coaxial ribbon cables 10a, 10b are connected to the multilayer printed circuit board 16e effectively at right angles by the relay connector 100d, as shown in Fig. 16. The relay connector 100d therefore comprises a set of signal leads 12a"', 12b"' formed from the set of signal leads 26a, 26b on the coaxial cable side and the set of signal leads 12a", 12b" on the printed circuit board side in a substantially straight arrangement, and a set of signal leads 13a"', 13b"', 13c"' formed from the set of ground leads 25a, 25b, 25c on the coaxial cable side and the set of signal leads 13a", 13b", 13c" on the printed circuit board side in a substantially straight arrangement.

The ground through hole 17b" which extends up to the ground layer 15b and is electrically connected to the ground interconnection 32bb of the ground layer 15b, and the signal through holes 30a", 30b" which have a depth substantially up to the signal layer 14a and are connected to the signal interconnection 34, are formed in the region connecting the relay connector 100d of the multilayer printed circuit board 16e.

Wide parts (anvil-shaped parts) 35 formed at the ends of the set of signal leads 12a" ', 12b" ' and wide parts of the set of ground leads 13a"', 13b"', 13c"' are respectively brought in contact with the pads 31b of the signal through holes 30a", 30b" and with the ground interconnections 32aa, 32ab, 32ac of the ground layer 15a, and are anchored using the solder 24 or an adhesive containing electrically conducting particles to form a package.

The three layer printed circuit board 16e has a one row stripline structure wherein the signal layer 14a is sandwiched by the ground layers 15a, 15b. The thickness between layers is about 0.4 mm.

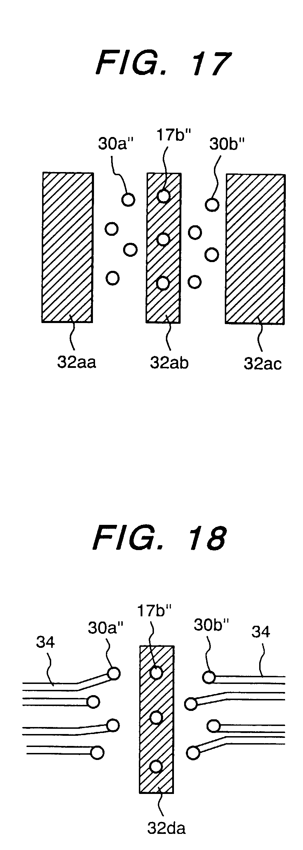

Fig. 17 shows a ground pattern or the like on the ground layer 15a of the multilayer printed circuit board 16e. As shown in Fig. 17, the ground interconnection 32 is removed from the vicinity of the signal through holes 30a", 30b", and all the ground through holes 17b" are connected to the ground interconnection 32ab. These ground interconnections 32aa, 32ab, 32ac have the function of the pads 31b connecting the set of ground leads 13a"', 13b"', 13c"'.

Fig. 18 shows a signal interconnection pattern or the like on the signal layer 14a of the multilayer printed circuit board 16e. As shown in Fig. 18, all of the ground through holes 17b" are connected to the ground interconnection 32da, and the signal wire 34 is connected to both of the signal through holes 30a", 30b".

Fig. 19 shows a ground pattern or the like on the ground layer 15b of the multilayer printed circuit board 16e. As shown in Fig. 19, the ground through holes 17b" are electrically connected to the ground interconnection 32bb.

As described above, the structure of the printed circuit board part of the relay connector 100 according to this invention (comprising, for example, the sets of two rows of signal leads 12a-12a"', 12b-12b"', and the sets of ground leads 13a-13a"', 13b-13b"', 13c-13c"'), is the stripline or coaxial transmission line structure shown in Fig. 25, Fig. 26, Fig. 27, Fig. 28 or Fig. 29. Further, as the connection with the multilayer printed circuit board having the stripline transmission line structure also has a stripline transmission line structure, parts containing a microstrip transmission line structure are eliminated, and spurious radiation can be reduced by at least about 20dB during high-speed signal transmission.

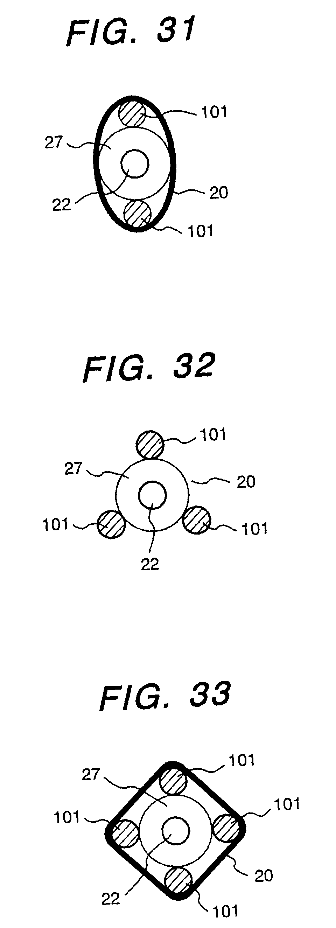

Apart from that shown in Fig. 2, the coaxial cable 28 according to this invention may be any of those shown in Fig. 30, Fig. 31, Fig. 32 or Fig. 33. Specifically, the coaxial cable is not limited to having one drain wire 101 as shown in Fig. 30, and the coaxial cables having plural drain wires 101 shown in Fig. 31, Fig. 32 and Fig. 33 may also be used to form the ground structure sandwiching the signal wire, and to enable two or more connections to be made to the ground of the coaxial cable easily. Fig. 31 shows a coaxial cable wherein two of the drain wires 101 are symmetrically disposed around the center conductor 22, Fig. 32 shows a coaxial cable wherein three of the drain wires 101 are point symmetrically disposed at 120 degree intervals around the center conductor 22, and Fig. 33 shows a coaxial cable wherein four of the drain wires 101 are symmetrically disposed around the center conductor 22.

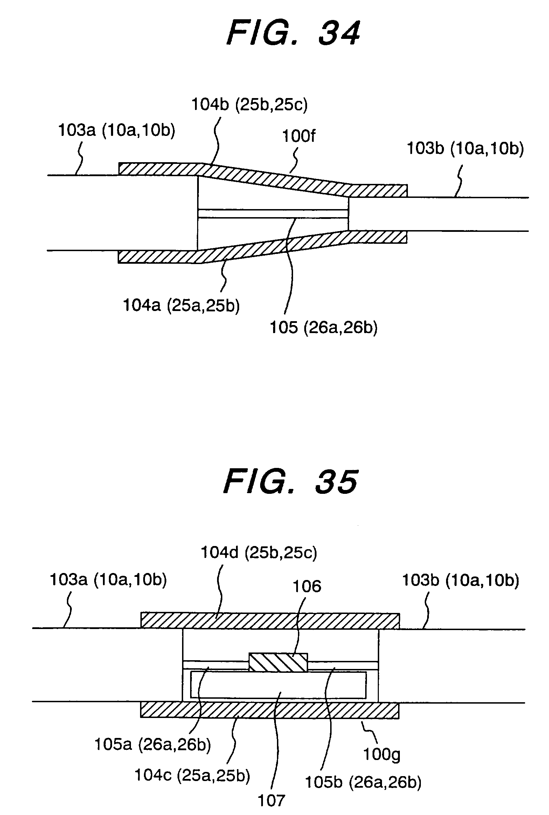

Next, a fourth embodiment relating to a connection between a coaxial cable 103a and coaxial cable 103b using a relay connector 100f according to this invention will be described referring to Fig. 34. This fourth embodiment comprises coaxial ribbon cables 10a, 10b such as were described in the first to third embodiments, and the relay connector 100f having a stripline transmission line structure for connecting, for example, the coaxial cable 103a and coaxial cable 103b which may have different dimensions (or the same dimensions) and for connecting between the coaxial cable 103a and coaxial cable 103b. The relay connector 100f comprises a set of signal leads 105 (26a, 26b) connected to the center conductors 22 of the coaxial cables 103a, 103b, and two ground planes (ground leads) 104a (25a, 25b), 104b (25b, 25c) connected by crimping or soldering to an extended part of the grounds 20 so as to face the upper surface and lower surface of the projecting ends of the grounds 20 of the coaxial cables 103a, 103b, these ground planes sandwiching the set of signal leads 105 from both sides so as to form a stripline transmission structure.

Next, a fifth embodiment wherein the coaxial cable 13a and coaxial cable 103b are connected by a relay connector 100g according to this invention, will be described referring to Fig. 35. The fifth embodiment comprises the coaxial cables 103a, 103b comprising the coaxial ribbon cables 10a, 10b described in the first-third embodiments, and the relay connector 100g having a stripline transmission line structure for connecting the coaxial cables 103a, 103b. The relay connector 100g comprises the set of signal leads 105a (26a, 26b) and set of signal leads 105b (26a, 26b) connected to the center conductors 22 of the coaxial cables 103a, 103b, an electronic circuit element 106 connected between the set of signal leads 105a (26a, 26b) and set of signal leads 105b (26a, 26b), a dielectric 107 on which the electronic circuit element 106 is mounted, and two ground planes (ground leads) 104c (25a, 25b), 104d (25b, 25c) connected by crimping or soldering to an extended part of the grounds 20 so as to face the upper surface and lower surface of the projecting ends of the grounds 20 of the coaxial cables 103a, 103b, these ground planes sandwiching the set of signal leads 105a, electronic circuit 106 and set of signal leads 105b from both sides, so as to form a stripline transmission structure. The set of signal leads 105a and set of signal leads 105b may also be formed on the dielectric 107.

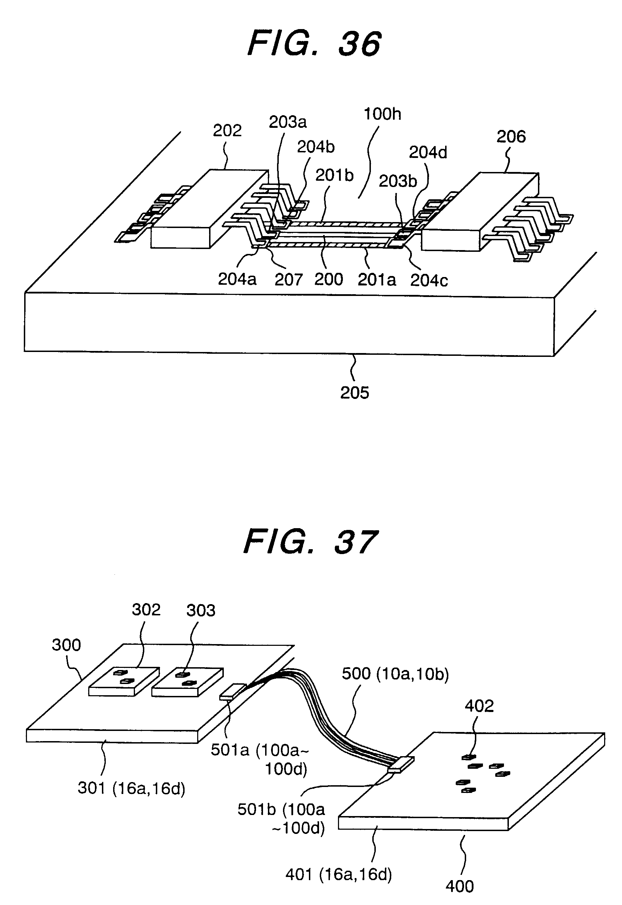

Next, a sixth embodiment wherein a LSI package 202 and LSI package 206, mounted on the surface of a substrate 205 such as a printed circuit board or the like, are connected by a relay connector 100h according to this invention, will be described referring to Fig. 36. The sixth embodiment comprises the LSI package 202 and LSI package 206 mounted on the surface of the printed circuit board, and a relay connector 100h having a stripline transmission line structure for connecting the LSI package 202 and LSI package 206. The relay connector 100h comprises a signal interconnection 200 wired on the printed circuit board 205 for connecting a signal lead 203a of the LSI package 202 to a signal lead 203b of the LSI package 206, a ground interconnection 201a wired on the printed circuit board 205 for connecting a ground lead 204a of the LSI package 202 to a ground lead 204c of the LSI package 206 so as to sandwich the signal interconnection 200, and a ground interconnection 201b wired on the printed circuit board 205 for connecting a ground lead 204b of the LSI package 202 to a ground lead 204c of the LSI package 206. The signal lead 203a of the LSI package 202 and signal lead 203b of the LSI package 206 are respectively connected to pads (electrodes) 207 formed at both ends of the signal interconnection 200, e.g. by solder or the like. The ground leads 204a, 204b of the LSI package 202 and ground leads 204c, 204d of the LSI package 206 are respectively connected to the pads (electrodes) 207 formed at both ends of the ground interconnection 201a and the ground interconnection 201b, e.g. by solder or the like. In other words, the relay connector 100h connecting the LSI package 202 to the LSI package 206 comprises the signal interconnection 200 wired on the printed circuit board 205, and the ground interconnections 201a, 201b wired on the printed circuit board 205 which sandwich this signal interconnection 200 between them.

Next, an embodiment will be described referring to Fig. 37 wherein a multilayer printed circuit board 301 (16a-16d) forming a CPU package 300 which is a mainframe computer, and a multilayer printed circuit board 401 (16a-16d) forming a clock package 400 which is a parallel computer, are connected by relay connectors 501a, 501b (100a-100d) according to this invention using plural coaxial cables 500 (10a, 10b). In the CPU package 300, which is a mainframe computer, plural multilayer ceramic printed circuit boards 302 on which plural LSI 303 are mounted, are mounted on the multilayer printed circuit board (platter) 301 (16a-16d) comprising three or more layers. In the clock package 400, which is a parallel computer, plural LSI 402 are mounted on the multilayer printed circuit board 401 (16a-16d). The multilayer printed circuit board 301 comprises any of the aforesaid multilayer printed circuit boards 16a-16d, and the multilayer printed circuit board 401 comprises any of the aforesaid multilayer printed circuit boards 16a-16d. The construction of the relay connector 501a which connects one end of the plural coaxial cables 500 to the multilayer printed circuit board 301, is that of any of the aforesaid relay connectors 100a-100d, and the construction of the relay connector 501b which connects the other end of the plural coaxial cables 500 to the multilayer printed circuit board 401, is that of any of the aforesaid relay connectors 100a-100d. Therefore, high-speed signals can be transmitted with less spurious radiation between the CPU package 300 which is a mainframe computer and the clock package 400 which is a parallel computer, and the whole system can be made more compact and economical.

According to this invention, a relay connector connecting a coaxial cable having a coaxial propagation mode and a multilayer printed circuit board having a stripline propagation mode, comprises a stripline transmission line which includes connections to the multilayer printed circuit board. Therefore, noise currents and spurious radiation generated due to discontinuities in the signal transmission mode are reduced, and a compact, low cost computer or computing system capable of high-speed signal transmission may be realized.

According to this invention, as the connection between the relay connector and multilayer printed circuit board is also a stripline transmission line structure, high-speed signal transmission is possible with less noise currents and spurious radiation due to discontinuities in the propagation mode, and a low EMI high speed circuit packaging structure which is both high-density and low cost can therefore be provided.

Further, according to this invention, as the connection between the relay connector and multilayer printed circuit board is also a stripline transmission line structure, high-speed signal transmission is possible with less noise currents and spurious radiation due to discontinuities in the propagation mode, and a low EMI high speed circuit packaging structure, wherein multilayer printed circuit boards comprising compact, high-density, low cost computers are connected by a relay connector using coaxial cable, can also be provided.

## Claims

1. A high speed circuit packaging structure comprising:
a coaxial cable formed in a coaxial propagation mode,
an electronic circuit, and
a relay connector which connects said coaxial cable and said electronic circuit in a stripline propagation mode which reduces noise currents and spurious radiation.

2. A high speed circuit packaging structure comprising:
a coaxial cable formed in a coaxial propagation mode,
a multilayer printed circuit board arranged in a stripline propagation mode and having three or more layers, and
a relay connector which connects said coaxial cable and said multilayer printed circuit board in a stripline propagation mode which reduces noise currents and spurious radiation

3. A high-speed circuit packaging structure comprising:
a coaxial cable formed in a coaxial propagation mode comprising a signal wire and surrounding ground disposed coaxially,
a multilayer printed circuit board arranged in a stripline propagation mode and having three or more layers comprising a set of signal through holes disposed in rows connected respectively to plural signal interconnections formed in a signal layer, and a pair of ground through holes connected to respective ground interconnections of a pair of ground layers sandwiching said signal layer, and sandwiching said set of plural signal through holes in a plane, and
a relay connector comprising a signal lead connecting a signal wire of said coaxial ribbon cable to signal through holes of said multilayer printed circuit board, and a pair of ground leads or ground plates connecting the ground of said coaxial cable to the pair of ground through holes of said multilayer printed circuit board so that said signal lead is symmetrically sandwiched, said connector being connected in a stripline propagation mode which reduces noise currents and spurious radiation.

4. A high-speed circuit packaging structure comprising:
a coaxial ribbon cable formed in a coaxial propagation mode comprising plural coaxial cables disposed parallel to each other comprising signal wires and surrounding grounds disposed coaxially,
a multilayer printed circuit board arranged in a stripline propagation mode and having three or more layers comprising a set of plural signal through holes disposed in rows connected respectively to plural signal interconnections formed in a signal layer, a set of plural pairs of ground through holes disposed in rows connected to respective ground interconnections of a pair of ground layers sandwiching said signal layer, and sandwiching said set of plural signal through holes in a plane, and
a relay connector comprising a set of plural signal leads connecting a set of plural signal wires of said coaxial ribbon cable to a set of plural signal through holes of said multilayer printed circuit board, and a set of plural pairs of ground leads or a set of ground plates connecting a set of plural grounds of said coaxial ribbon cable to a set of plural pairs of ground through holes of said multilayer printed circuit board so that said set of plural signal leads is symmetrically sandwiched, said connector being connected in a stripline propagation mode which reduces noise currents and spurious radiation.

5. A high speed circuit packaging structure wherein, in the relay connector of Claim 3 or 4, the signal lead and pair of ground leads or ground plates are bent along their length.

6. A high speed circuit packaging structure wherein, in the multilayer printed circuit board of Claim 3 or 4, the signal through hole is disposed such that it has substantially the depth of the signal layer.

7. A high speed circuit packaging structure wherein, in the multilayer printed circuit board of Claim 3 or 4, a ground interconnection pattern which is electrically connected to the ground through holes is also provided in the signal layer.

8. A high speed circuit packaging structure wherein, in the relay connector of Claim 3 or 4, the ends of the signal lead and pair of ground leads or ground plates are bent, and the bent ends are pressed into and brought into contact with the interior of the signal through hole and pair of ground through holes in the multilayer printed circuit board.

9. A high-speed circuit packaging structure comprising:
a first multilayer printed circuit board comprising a computer on which an LSI is mounted, arranged in a stripline propagation mode and having three or more layers, and comprising a set of plural signal through holes disposed in rows connected respectively to plural signal interconnections formed in a signal layer, a set of plural pairs of ground through holes disposed in rows connected to respective ground interconnections of a pair of ground layers sandwiching said signal layer, and sandwiching said set of plural signal through holes in a plane,
a second multilayer printed circuit board comprising a computer on which an LSI is mounted, arranged in a stripline propagation mode and having three or more layers, and comprising a set of plural signal through holes disposed in rows connected respectively to plural signal interconnections formed in a signal layer, a set of plural pairs of ground through holes disposed in rows connected to respective ground interconnections of a pair of ground layers sandwiching said signal layer, and sandwiching said set of plural signal through holes in a plane,
a coaxial ribbon cable formed in a coaxial propagation mode comprising plural coaxial cables disposed parallel to each other comprising signal wires and surrounding grounds disposed coaxially,
a first relay connector comprising a set of plural signal leads connecting a set of plural signal wires of said coaxial ribbon cable to a set of plural signal through holes of said first multilayer printed circuit board, and a set of plural pairs of ground leads or a set of ground plates connecting a set of plural grounds of said coaxial ribbon cable to a set of plural pairs of ground through holes of said first multilayer printed circuit board so that said set of plural signal leads is symmetrically sandwiched, said connector being connected in a stripline propagation mode which reduces noise currents and spurious radiation, and
a second relay connector comprising a set of plural signal leads connecting a set of plural signal wires of said coaxial ribbon cable to a set of plural signal through holes of said first multilayer printed circuit board, and a set of plural pairs of ground leads or a set of ground plates connecting a set of plural grounds of said coaxial ribbon cable to a set of plural pairs of ground through holes of said first multilayer printed circuit board so that said set of plural signal leads is symmetrically sandwiched, said connector being connected in a stripline propagation mode which reduces noise currents and spurious radiation.

10. A high speed circuit packaging structure comprising:
a pair of LSI packages mounted on a printed circuit board, and
an interconnection structure formed on said printed circuit board for the purpose of connecting one LSI package to the other LSI package, wherein a signal interconnection is sandwiched between ground interconnections, and having a stripline propagation mode which reduces noise currents and spurious radiation.
